# EUROPEAN PATENT APPLICATION

(11) **EP 4 657 515 A1**
(43) Date of publication of application: **03.12.2025**
(21) Application number: 23950094.5
(22) Date of filing: 29.08.2023
(51) Int. Cl.: H01L 21/768

(54) **SEMICONDUCTOR STRUCTURE AND METHOD FOR FORMING SAME, AND SEMICONDUCTOR DEVICE**

(71) Applicant: Yangtze Memory Technologies Co., Ltd., Wuhan, Hubei 430000 (CN)
(72) Inventor: HUANG, Wugen, Wuhan, Hubei 430000 (CN); MIAO, Lina, Wuhan, Hubei 430000 (CN); XIAO, Liang, Wuhan, Hubei 430000 (CN); ZHANG, Mingkang, Wuhan, Hubei 430000 (CN)
(74) Representative: Lippert Stachow Patentanwälte Rechtsanwälte
(86) International application number: PCT/CN2023/115610
(87) International publication number: WO 2025/043502

(57) **Abstract**

The present disclosure relates to a semiconductor structure, a forming method thereof and a semiconductor device. The semiconductor structure includes: a stack structure; a semiconductor layer on the stack structure; a channel structure extending through the stack structure and into the semiconductor layer; a contact structure extending along a stacking direction of the stack structure; and a first soldering structure and a second soldering structure, wherein the first soldering structure penetrates through the semiconductor layer and is connected with the contact structure and the second soldering structure is connected with the semiconductor layer.

## Description

### TECHNICAL FIELD

The present disclosure relates to the field of semiconductor technology and in particular to a semiconductor structure, a forming method thereof and a semiconductor device.

### BACKGROUND

3D memories are an emerging type of flash memories, in which multiple tiers of data storage cells are stacked vertically to overcome the limitations of 2D or planar flash memories. 3D memories have excellent precision, support higher capacity within a smaller footprint, have low costs and power consumption, and can fully satisfy various demands.

However, 3D memories still face many challenges.

### SUMMARY

The present disclosure provides a semiconductor structure, a forming method thereof and a semiconductor device to solve the problem of relatively high complexity and cost of both a semiconductor structure and the technical process thereof due to the special requirements of various conductive via structures and solder pads in terms of materials in semiconductor structures.

In order to solve the above-mentioned problem, a technical solution of the present disclosure is implemented as follows.

The present disclosure provides a semiconductor structure, including:
a stack structure;
a semiconductor layer on the stack structure;
a channel structure extending through the stack structure and into the semiconductor layer;
a contact structure extending along a stacking direction of the stack structure; and
a first soldering structure and a second soldering structure, wherein the first soldering structure penetrates through the semiconductor layer and is connected with the contact structure and the second soldering structure is connected with the semiconductor layer.

In an example of the present disclosure, each of the first soldering structure and the second soldering structure includes a first portion and a second portion on the first portion, wherein a size of the second portion in a first direction is larger than a size of the first portion in the first direction with the first direction being perpendicular to the stacking direction.

In an example of the present disclosure, the size of the first portion in the first direction is the first size and a size of the first portion in the stacking direction is the second size with a ratio of the second size to the first size being smaller than 1:5.

In an example of the present disclosure, the first portion and the second portion are formed integrally.

In an example of the present disclosure, a portion of the channel structure extending into the semiconductor layer has a size along the stacking direction smaller than 200nm.

In an example of the present disclosure, a top surface of the semiconductor layer right above the channel structure is flush with a top surface of the semiconductor layer right above the stack structure.

In an example of the present disclosure, a top surface of the semiconductor layer right above the channel structure is higher than a top surface of the semiconductor layer right above the stack structure.

In an example of the present disclosure, a material of the first soldering structure and a material of the second soldering structure both comprise aluminum.

In an example of the present disclosure, the semiconductor structure further includes: an isolating structure located at least between the first soldering structure and the semiconductor layer.

In an example of the present disclosure, the stack structure includes first material layers and insulating layers that are stacked alternately, and has a third portion and a fourth portion that are arranged side by side in a direction perpendicular to the stacking direction; the contact structure extends through the third portion and the channel structure extends through the fourth portion; and the first material layers in the third portion include sacrificial layers and the first material layers in the fourth portion include conductive layers.

In an example of the present disclosure, the channel structure includes a functional layer located in the stack structure and a channel layer located in the stack structure and extending into the semiconductor layer with the functional layer covering the sidewall of the channel layer in the stack structure.

In order to solve the above-mentioned problem, the present disclosure further provides a semiconductor device, which includes a first semiconductor structure and the semiconductor structure as described in any one of the examples above;
wherein the first semiconductor structure is located on the one of the two opposite sides of the semiconductor structure away from the semiconductor layer in the stacking direction and is connected with the semiconductor structure through hybrid bonding.

In an example of the present disclosure, the first semiconductor structure includes:
a peripheral circuitry connected with the contact structure in the semiconductor structure.

In order to solve the above-mentioned problem, the present disclosure further proposes a forming method of a semiconductor structure, which includes:
providing a stack structure, a contact structure and a channel structure, wherein the channel structure penetrates through the stack structure and protrudes above the stack structure and the contact structure extends in a stacking direction of the stack structure;
forming a semiconductor layer over the stack structure and the channel structure from the side where the channel structure protrudes above the stack structure; and
forming a first soldering structure and a second soldering structure, wherein the first soldering structure penetrates through the semiconductor layer and is connected with the contact structure and the second soldering structure is connected with the semiconductor layer.

In an example of the present disclosure, the forming the semiconductor layer over the stack structure and the channel structure includes:
forming a semiconductor material layer over each of the stack structure, the channel structure and the contact structure, wherein top surfaces of the semiconductor material layers right above the channel structure and the contact structure are higher than a top surface of the semiconductor material layer right above the stack structure; and removing a portion of the semiconductor material layer to form a first opening exposing the contact structure and the remaining of the semiconductor material layer forms the semiconductor layer.

In an example of the present disclosure, the forming the semiconductor layer over the stack structure and the channel structure further includes:
planarizing the semiconductor material layer before forming the first opening, so that the top surface of the semiconductor material layer right above the channel structure is flush with the top surface of the semiconductor material layer right above the stack structure.

In an example of the present disclosure, the method further includes: forming an isolating layer covering the sidewall and bottom of the first opening as well as the semiconductor layer; and
removing at least a portion of the isolating layer on the bottom of the first opening to expose the contact structure; and removing a portion of the isolating layer on the semiconductor layer to form a second opening, through which the semiconductor layer is exposed, with the remaining portion of the isolating layer forming the isolating structure.

In an example of the present disclosure, the forming the first soldering structure and the second soldering structure includes:
after forming the isolating structure, forming the first soldering structure at least in the first opening and forming the second soldering structure at least in the second opening, wherein each of the first soldering structure and the second soldering structure includes a first portion and a second portion on the first portion, and the first portion of the first soldering structure is located in the first opening and the second portion of the second soldering structure is located in the second opening.

In an example of the present disclosure, the providing the stack structure, the contact structure and the channel structure includes:
forming the stack structure, the contact structure and the channel structure on a base structure, wherein the base structure includes a substrate and a first semiconductor layer between the substrate and the stack structure, the channel structure extending into the first semiconductor layer; or the base structure includes a substrate and the channel structure extends into the substrate; and
removing the base structure to expose a portion of the channel structure.

In an example of the present disclosure, the channel structure includes a channel layer and a functional layer surrounding the channel layer, and after removing the base structure to expose a portion of the functional layer, the method further includes:
after removing the base structure, removing the exposed portion of the functional layer to expose a portion of the channel layer.

### BRIEF DESCRIPTION OF DRAWINGS

In order to make the purpose, features and advantages of the present disclosure more apparent and easier to understand, specific implementations of the disclosure will be described in detail below with reference to accompanying drawings, wherein
Fig. 1 is a schematic diagram of a semiconductor structure in some examples;
Fig. 2A is the first diagram illustrating cross sections of a semiconductor structure along the line AA' and the line BB' in an example of the present disclosure;
Fig. 2B is a top view of a semiconductor structure provided in an example of the present disclosure;
Figs. 3A and 3B are structural diagrams of a first part and a second part provided in an example of the present disclosure;
Fig. 4 is the second diagram illustrating cross sections of a semiconductor structure along the line AA' and the line BB' in an example of the present disclosure;
Fig. 5 is the third diagram illustrating cross sections of a semiconductor structure along the line AA' and the line BB' in an example of the present disclosure;
Fig. 6 is a flow diagram of a forming method of a semiconductor structure provided in an example of the present disclosure;
Figs. 7 to 21 are cross-sectional views along the line AA' and the line BB' illustrating a forming process of a semiconductor structure provided in an example of the present disclosure; and
Figs. 22 and 23 are cross-sectional views along the line AA' and the line BB' illustrating a forming process of a semiconductor device provided in an example of the present disclosure.

### DETAILED DESCRIPTION

In order to make the above purpose, features and advantages of the disclosure more apparent and easier to understand, specific implementations of the disclosure will be described in detail below with reference to accompanying drawings.

Many details are set forth below in the following description to make the present disclosure be fully understood. However, the present disclosure can be implemented in other implementations different from those described herein and as a result is not limited by the specific examples disclosed hereafter.

As used in the present application and claims, terms such as "a", "an" and/or "the" may also include the plural sense instead of indicating only the singular sense, unless indicated otherwise explicitly in the context. Generally, terms "including" and "comprising" only indicate that the steps and elements listed explicitly are included, but will not constitute an exclusive list; and other steps or elements may also be included in a method or an apparatus.

In detailed description of examples of the present disclosure, for easy illustration, cross-sections depicting device structures are partially exaggerated instead of being drawn to general scale. The diagrams are just illustrative and in no way limit the scope of the present disclosure. Additionally, three-dimension spatial sizes of length, width and depth may be involved in practical fabrication.

For easy description, terms for spatial relationships, such as "under", "below", "lower", "beneath", "above" and "on", may be used herein to describe the relationship of one element or feature with respect to another element or feature in a drawing. It is to be understood that those terms for spatial relationships are intended to include orientations of a device in use or operation other than those depicted in the drawings. For example, if a device is turned upside down, an element described to be "below", "under" or "beneath" another element or feature will instead have an orientation of being "above" said another element or feature. Therefore, example terms "beneath" and "under" may include orientations of both "below" and "above". The device can be otherwise oriented (rotated 90 degrees or at other orientations) and the spatially relative descriptors used herein can likewise be interpreted accordingly. Additionally, it is to be understood that when a layer is referred to be located "between" two layers, it may be the only one layer located therebetween or there may be one or more other layers located between the two layers.

In the context of the present application, a structure in which a first feature is located "on" a second feature described above may include an example in which the first feature and the second feature are formed in direct contact with each other, or include an example in which an additional feature is formed between the first feature and the second feature, so that the first feature and the second feature may be not in direct contact with each other.

Additionally, it is to be noted that when terms, for example, "first", "second" etc., are used to define parts, they are only intended to distinguish one part from another, and if there are no otherwise statements, the above-mentioned terms have no special meaning, and cannot be interpreted as a limitation to the scope claimed by the present application.

As used herein, the term "3D memory" refers to a semiconductor device with vertically oriented strings of memory cell transistors (referred to herein as "memory strings," such as NAND strings) on a laterally-oriented substrate so that the memory strings extend in the vertical direction with respect to the substrate. As used herein, the term "vertical/vertically" means nominally perpendicular to a lateral surface of a substrate.

As used herein, the term "substrate" refers to a material onto which subsequent material layers are added. The substrate itself can be patterned. The materials added on top of the substrate can be patterned or can remain unpatterned. Furthermore, the substrate can include a wide array of semiconductor materials, such as silicon, germanium, gallium arsenide, indium phosphide, etc. Alternatively, the substrate can be made from a non-conductive material, such as glass, plastic, or a sapphire wafer.

As used in the present application, the term "layer" refers to a material portion including a region with a thickness. A layer can extend over the entirety of an underlying or overlying structure or may have an extent less than the extent of an underlying or overlying structure. Further, a layer can be a region of a homogeneous or inhomogeneous continuous structure that has a thickness less than the thickness of the continuous structure. For example, a layer can be located between any pair of horizontal planes between or at a top surface and a bottom surface of the continuous structure. A layer can extend horizontally, vertically, and/or along a tapered surface. A substrate can be a layer, can include one or more layers therein, and/or can have one or more layer thereupon, thereabove, and/or therebelow. A layer may include a plurality of layers. For example, an interconnect layer can include one or more conductor and contact layers (in which contacts, interconnect lines and/or vias are formed) and one or more dielectric layers.

A flow chart is used in the present application to illustrate operations performed by the system in accordance with examples of present application. It is to be understood that operations described above and below may not necessarily performed in an exact order. Instead, various steps can be processed in an inverse order or simultaneously. Meanwhile, other operations may be added to those processes or one or more operations may be eliminated from the processes.

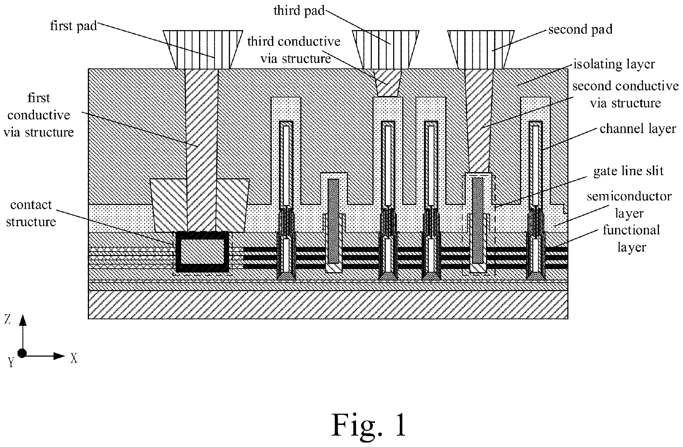

In some examples, as shown in Fig. 1, a channel structure of a semiconductor structure includes a functional layer and a channel layer with the functional layer covering a portion of sidewalls of the channel layer. In some examples, in a process of forming the channel structure, a depth of a portion of the channel structure extending beyond a stack structure is difficult to be controlled to be within a small range, such that a portion of the channel layer uncovered by the finally formed functional layer has a relatively large height in Z direction. The semiconductor structure further includes a contact structure, a gate line slit (GLS) structure and a channel structure. A semiconductor layer covers the top of the gate line slit structure and is covered by an isolating layer thereon. In the case that a height of a top of the channel structure and a height of a top of semiconductor layer on top of the gate line slit structure are much below a height of a top of the isolating layer, in order to pad out the contact structure and the channel structure, a first conductive via structure that penetrates through the isolating layer and is connected with the contact structure, a second conductive via structure that penetrates through the isolating layer and is connected with the semiconductor layer on top of the gate line slit structure and/or a third conductive via structure that penetrates through the isolating layer and is connected with the semiconductor layer on top of the channel structure may be disposed. It is to be noted that the "top" mentioned above means the highest point of the semiconductor structure in the Z direction. Further, a first pad may be disposed above the first conductive via structure, a second pad may be disposed above the second conductive via structures and a third pad may be disposed above the third conductive via structures.

It is to be understood that, since the portion of channel layer uncovered by the functional layer has a relatively large height in the Z direction in the above-described semiconductor structure, such that the isolating layer has a relatively large thickness in the Z direction and furthermore the above-described conductive via structures may each have a relatively large aspect ratio. Moreover, the conductive via structures have a conductive material filled therein and since aluminum has poor step coverage, it is not suitable for the conductive via structures with a relatively large aspect ratio as shown in Fig. 1. For filling of a via with a relatively large aspect ratio, tungsten can be considered, but it has a relatively high cost. Moreover, since the pads may also be used in a test stage, a metal material that is not easily deformed can be chosen, a material used in various pads may be aluminum. Due to special requirements for materials of the conductive via structures and the pads in the above-described semiconductor structure, the semiconductor structure and process procedure thereof are complicated and have a high process cost.

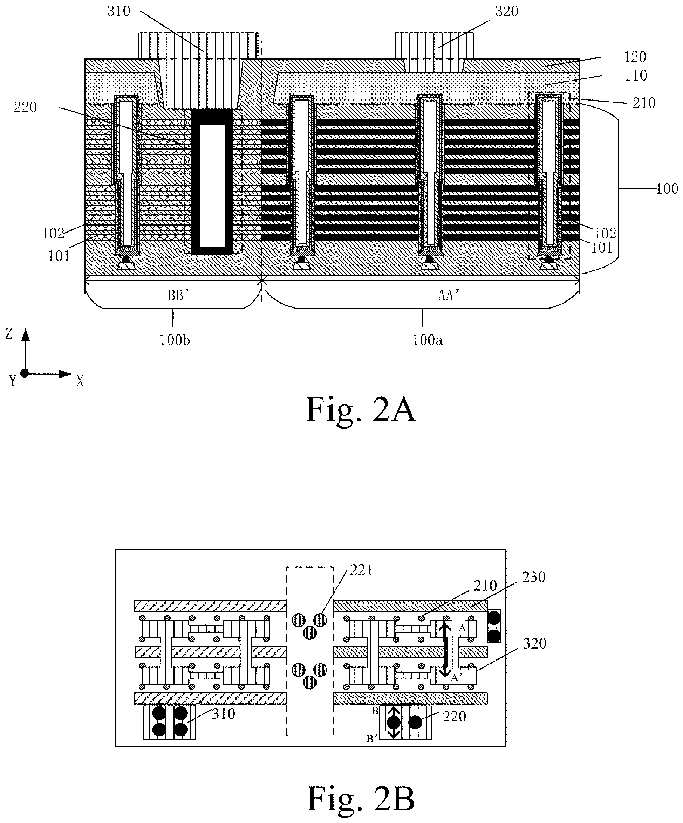

In order to solve one or more of the problems above, with reference to Figs. 2A and 2B, a semiconductor structure is provided in an example of the present disclosure. The semiconductor structure includes:
a stack structure 100; a semiconductor layer 110 on the stack structure 100; a channel structure 210 extending through the stack structure 100 in the Z direction and into the semiconductor layer 110; and a contact structure 220 extending along the stacking direction (i.e., the Z direction) of the stack structure 100. Fig. 2A is a cross-sectional view of a semiconductor structure along the line AA' and the line BB' in Fig. 2B provided in the present disclosure and Fig. 2B is a top view of the semiconductor structure provided in the present disclosure. In Figs. 2A and 2B, the numbers of the channel structures 210, contact structures 220 and gate line slit structures 230 are only examples and have no correspondence with each other. A contact region is also included in Fig. 2B. The contact region includes a plurality of word line contact structures 221 configured to pad out word lines in the stack structure 100. Fig. 2B further includes a first soldering structure 310 configured to pad out the contact structure 220 and a second soldering structure 320 configured to pad out the channel structure 210.

In some examples, the channel structure 210 includes a functional layer located in the stack structure 100 and a channel layer located in the stack structure 100 and extending into the semiconductor layer 110 with the functional layer covering sidewalls of the channel layer in the stack structure 100. A portion of the channel layer extending into the semiconductor layer 110 is uncovered by the functional layer. A height of the portion of the channel layer extending into the semiconductor layer 110 in the Z direction is smaller than a preset value.

In some examples, the functional layer includes a blocking layer, a trapping layer and a tunneling layer. The material of the channel layer includes, but not limited to, polysilicon.

In some examples, the portion of the channel structure 210 extending into the semiconductor layer 110 has a size in the stacking direction smaller than 200nm. That is, the first preset value is 200nm.

It is to be noted that the first preset value given in the example above is only exemplary and not used to limit a specific value of the first preset value in examples of the present disclosure.

The semiconductor structure shown in Fig. 2A further includes a first soldering structure 310 penetrating through the semiconductor layer 110 and connected with the contact structure 220 and a second soldering structure 320 connected with the semiconductor layer 110. The first soldering structure 310 is configured to pad out the contact structure 220 and the second soldering structure 320 is configured to pad out the channel structure 210. It is to be noted that the second soldering structure 320 is configured to pad out the channel structure 210 indirectly through the semiconductor layer 110, rather than directly padding out the channel structure 210.

In some specific examples, the material of the semiconductor layer 110 includes, but not limited to, polysilicon. The semiconductor layer 110 may be used as a source layer.

It is to be understood that, in examples of the present disclosure, based on a relatively small size of the portion of the channel structure 210 extending into the semiconductor layer 110 along the stacking direction and a relatively small size of the semiconductor layer 110 along the stacking direction, the first soldering structure 310 is made to be in direct contact with the contact structure 220 and the second soldering structure 320 is made to be in direct contact with the semiconductor layer 110. That is to say, padding out of the contact structure 220 and the channel structure 210 can be achieved directly by the second soldering structure 320 and the first soldering structure 310 without the need of forming contact structures filled with tungsten between the first soldering structure 310 and the contact structure 220 and between the second soldering structure 320 and the semiconductor layer 110, so that the semiconductor structure is simplified, the corresponding process steps are saved and the process cost is reduced.

In some examples, the material of the first soldering structure 310 and the material of the second soldering structure 320 can each include aluminum, but the materials of the first soldering structure 310 and the second soldering structure 320 are not limited to this.

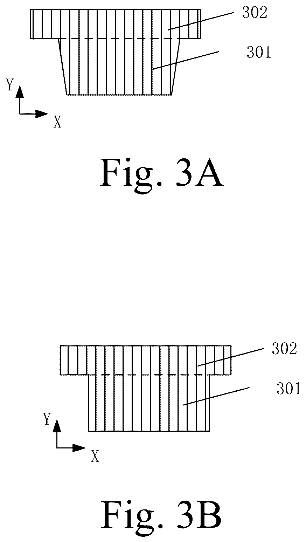

In some examples, as shown in Figs. 3A and 3B, each of the first soldering structure 310 and the second soldering structure 320 includes a first portion 301 and a second portion 302 on the first portion 301; wherein a size of the second portion 302 in a first direction (i.e., X direction) is larger than a size of the first portion 301 in the first direction with the first direction being perpendicular to the stacking direction (i.e., the Z direction).

In some examples, the size of the first portion 301 in the first direction is first size and the size of the first portion 301 in the stacking direction is second size with the ratio of the second size to the first size being smaller than 1:5.

It is to be noted that, as shown in Fig. 3A, the first portion 301 may have a shape of inverted trapezoid, for which the first sizes taken at different heights along the Z direction have different values and may be the smallest size of the inverted trapezoid in the X direction, i.e. the size at the bottom of the first portion 301 in the X direction in Fig. 3A. In some examples, as shown in Fig. 3B, the first portion 301 may have a shape of rectangle and the first sizes taken at different heights along the Z direction are the same and the first size may be the size of the rectangle in the X direction at an arbitrary height along the Z direction.

In some examples, the first portion 301 and the second portion 302 may be formed integrally. In this way, the process flow may be simplified, process time can be saved, process cost can be reduced and complexity of the wiring process can be lowered.

In examples of the present disclosure, the first portion 301 and the second portion 302 use the same conductive material including, but not limited to, aluminum.

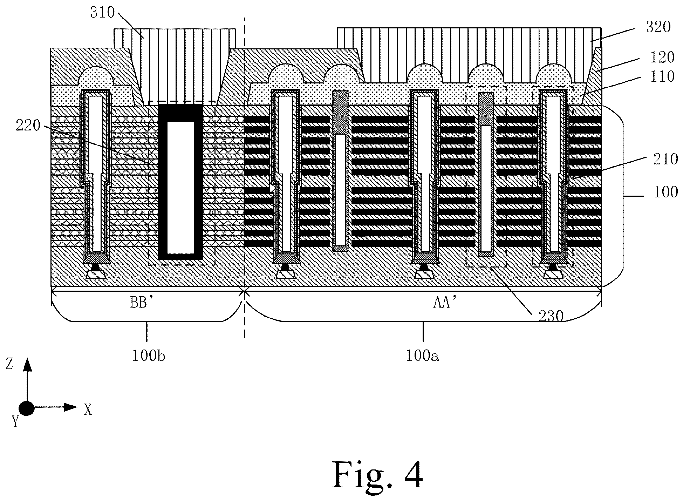

In some examples, as shown in Fig. 4, a top surface of the semiconductor layer 110 right above the channel structure 210 is higher than a top surface of the semiconductor layer 110 right above the stack structure 100.

In examples of the present disclosure, the upper surface of the semiconductor layer 110 has irregular morphology that is associated with a profile of the portion of the channel structure 210 protruding above the stack structure 100.

Specifically, the semiconductor layer 110 that has an upper surface with irregular morphology can be formed by depositing a semiconductor material over the stack structure 100 and the sidewalls and top surface of the channel structure 210 with a deposition/epitaxial growth process, and has the same thickness in the Z direction. Since the channel structure 210 protrudes above the stack structure 100, the top surface of the semiconductor layer 110 right above the channel structure 210 is higher than the top surface of the semiconductor layer 110 right above the stack structure 100.

In some examples, as shown in Fig. 4, the semiconductor structure further includes a gate line slit structure 230 extending through the stack structure 100 and into the semiconductor layer 110. It can be understood that a top surface of the semiconductor layer 110 right above the gate line slit structure 230 may also be higher than the top surface of the semiconductor layer 110 right above the stack structure 100.

In some particular examples, a material of the gate line slit structure 230 may be one or more of a dielectric material, such as silicon oxide, silicon nitride or silicon oxynitride, and a semiconductor material such as polysilicon.

In some examples, as shown in Fig. 2A, the top surface of the semiconductor layer 110 right above the channel structure 210 is flush with the top surface of the semiconductor layer 110 right above the stack structure 100.

Specifically, in a corresponding forming process, the semiconductor layer 110 that has the upper surface with irregular morphology as shown in Fig. 4 may be formed first and then have its top surface planarized by chemical mechanical polishing (CMP), which finally results in the semiconductor layer 110 having a surface that is flat in the X direction as shown in Fig. 2A.

In some examples, as shown in Fig. 2, the stack structure 100 includes first material layers 101 and insulating layers 102 that are stacked alternately, and has a third portion 100b (e.g., a contact region) and a fourth portion 100a (e.g., an array region) that are arranged side by side in a direction perpendicular to the stacking direction. The contact structure 220 penetrates through the third portion 100b and the channel structure 210 penetrates through the fourth portion 100a. The first material layers 101 in the third portion 100b include sacrificial layers and the first material layers 101 in the fourth portion 100a include conductive layers.

In examples of the present disclosure, the conductive layers in the fourth portion 100a may be formed by replacing the sacrificial layers. During replacement, the sacrificial layers in the third portion 100b are not replaced and the contact structure 220 in the third portion 100b may provide support for the stack structure 100.

In some specific examples, the materials used in the conductive layers may include one or more of the conductive materials such as tungsten, cobalt, copper, aluminum, and metal silicide. The materials used in the sacrificial layers may include, but not limited to, silicon nitride. The materials used in insulating layers 102 may include, but not limited to, silicon oxide.

In some examples, as shown in Fig. 2A, the semiconductor structure further includes:
an isolating structure 120 located at least between the first soldering structure 310 and the semiconductor layer 110.

In examples of the present disclosure, the isolating structure 120 is configured to isolate the first soldering structure 310 from the semiconductor layer 110, so that the first soldering structure 310 and the second soldering structure 320 can pad out the contact structure 220 and the channel structure 210 respectively. In some specific examples, the materials of the isolating structure 120 may include, but not limited to, silicon oxide.

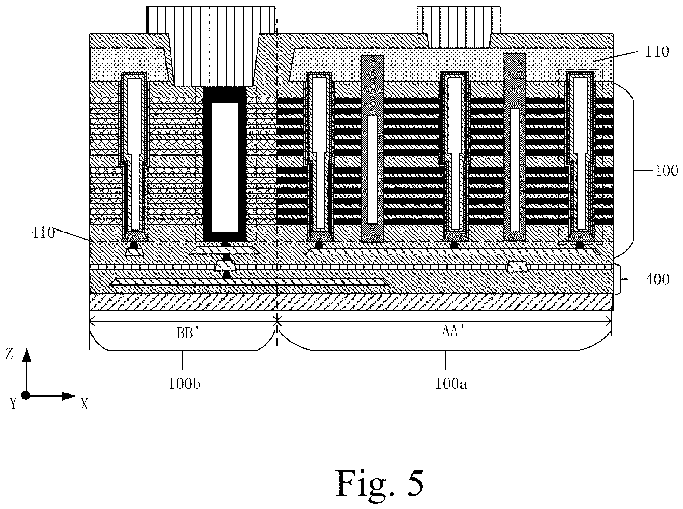

Examples of the present disclosure provide a semiconductor device that, as shown in Fig. 5, includes a first semiconductor structure 400 and the semiconductor structure as described in any example above.

The first semiconductor structure 400 is located on one of two opposite sides of the semiconductor structure away from the semiconductor layer 110 along the stacking direction and is connected with the semiconductor structure through hybrid bonding.

In some examples, the first semiconductor structure 400 includes:
a peripheral circuitry connected with the contact structure 220 in the semiconductor structure.

In some examples, the semiconductor structure includes a first bonding layer located on one of the two opposite sides of the semiconductor structure away from the semiconductor layer 110 along the Z direction. The first semiconductor structure 400 further includes a second bonding layer. The first and second bonding layers can be bonded through a hybrid bonding process.

In some examples, the first semiconductor structure 400 and the semiconductor structure provided in examples of the present disclosure can be bonded through a fusion bonding process or a direct wafer bonding process and the side of the substrate away from the stack structure 100 is made facing upwards after bonding.

It is to be noted that, in the example of the present disclosure, the case, in which a memory array wafer including the stack structure 100 is bonded to the first semiconductor structure 400 including the peripheral circuitry and then the subsequent backside pad-out process is performed from the side of the substrate away from the stack structure 100, is taken as an example, however in some other examples, the memory array wafer and the first semiconductor structure 400 including the peripheral circuitry can be bonded after the backside pad-out process is performed, or only the memory array wafer is formed and the backside pad-out process is performed on the memory array wafer.

In some specific examples, as shown in Fig. 5, the contact structure 220 may be connected with the peripheral circuitry in the first semiconductor structure 400 through interconnecting structure in an interconnecting layer 410. The peripheral circuitry may include complementary metal oxide semiconductor (CMOS) devices and metal oxide semiconductor (MOS) devices. The CMOS devices and the MOS devices in the peripheral circuitry may be electrically padded out through the interconnecting structure, the contact structure 220 and the first soldering structure 310. The first soldering structure 310 may be configured to receive a first voltage, which is transferred to the peripheral circuitry through the contact structure 220. The second soldering structure 320 may be configured to receive the second voltage, which is received by the semiconductor layer 110 and transferred to a plurality of channel structures 210 as a source voltage. By using the isolating structure 120 between the first soldering structure 310 and the semiconductor layer 110, the first soldering structure 310 and the second soldering structure 320 would not interfere with each other.

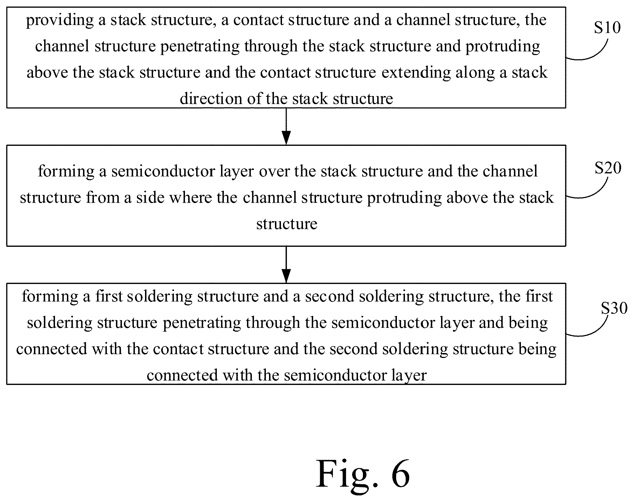

Examples of the present disclosure provide a forming method of a semiconductor structure. Fig. 6 is a flow diagram of a forming method of a semiconductor structure provided in an example of the present disclosure. As shown in Fig. 6, the forming method of the semiconductor structure includes the following steps.

Step S10: providing a stack structure, a contact structure and a channel structure, wherein the channel structure penetrates through the stack structure and protrudes above the stack structure and the contact structure extends in the stacking direction of the stack structure;

Step S20: forming a semiconductor layer over the stack structure and the channel structure from the side where the channel structure protrudes above the stack structure;

Step S30: forming a first soldering structure and a second soldering structure, wherein the first soldering structure penetrates through the semiconductor layer and is connected with the contact structure and the second soldering structure is connected with the semiconductor layer.

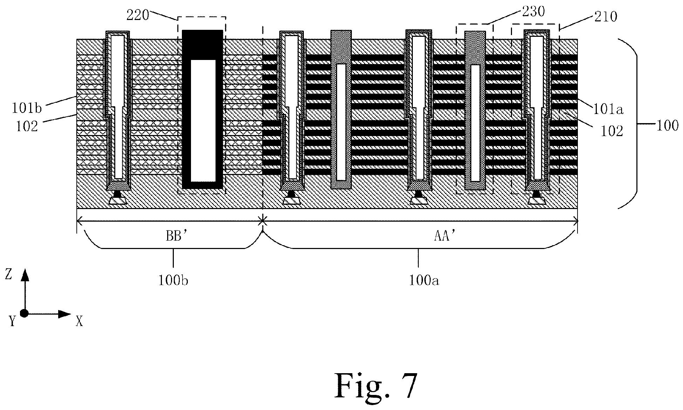

Figs. 7 to 19 are structural diagrams illustrating a forming process of a semiconductor structure provided in an example of the present disclosure. Hereafter, a forming method of a semiconductor structure provided in an example of the present disclosure will be described in detail with reference to Figs. 6 to 19.

With reference to Fig. 7, step S10 is performed, in which the stack structure 100, the contact structure 220 and the channel structure 210 are provided, and the channel structure 210 penetrates through the stack structure 100 and protrudes above the stack structure 100 and the contact structure 220 extends in the stacking direction of the stack structure 100.

In some examples, the stack structure 100 includes a third portion 100b (e.g., a contact region) and a fourth portion 100a (e.g., an array region) that are arranged side by side in a direction perpendicular to the stacking direction. The third portion 100b includes sacrificial layers 101b and insulating layers 102 that are arranged sequentially along the Z direction. The fourth portion 100a includes conductive layers 101a and insulating layers 102 that are arranged sequentially along the Z direction.

In some specific examples, a base structure may be provided first, which may include a first region and a second region arranged side by side in the X direction. The process of forming the stack structure 100 includes: forming the insulating layers 102 and sacrificial layers 101b stacked alternately along the Z direction on both the first region and the second region by using a deposition process; forming a gate line slit (GLS) and then removing the sacrificial layers 101b on the second region with the sacrificial layers 101b on the first region remaining; and depositing the conductive layers 101a at locations where the sacrificial layers 101b on the second region have been removed. As a result, the third portion 100b of the stack structure 100 is formed on the first region and the fourth portion 100a of the stack structure 100 is formed on the second region. In some specific examples, the method further includes filling the gate line slit to form a gate line slit structure 230.

It is to be noted that numbers of the sacrificial layers 101b, insulating layers 102 and conductive layers 101a in Fig. 7 are only exemplary and not limited so in the present disclosure. It is to be understood that the number of the sacrificial layers 101b is the same as that of the conductive layers 101a.

In examples of the present disclosure, the deposition process includes, but not limited to, chemical vapor deposition (CVD), low pressure chemical vapor deposition (LPCVD), plasma enhanced chemical vapor deposition (PECVD), physical vapor deposition (PVD) and atomic layer deposition (ALD).

In examples of the present disclosure, the channel structure 210 includes a functional layer and a channel layer with the functional layer covering a portion of the sidewalls of the channel layer. A top surface of the functional layer is flush with the top surface of the stack structure 100 and the channel layer protrudes above the top surface of the stack structure 100. The channel structure 210 is formed by etching an initial channel structure. The initial channel structure includes an initial functional layer and a channel layer with the initial functional layer covering the sidewalls and top surface of the channel layer. A portion of the initial functional layer above the stack structure 100 is removed to form the functional layer.

In examples of the present disclosure, materials of the contact structure 220 may be one or more of conductive materials such as tungsten, cobalt, copper, aluminum, and a metal silicide.

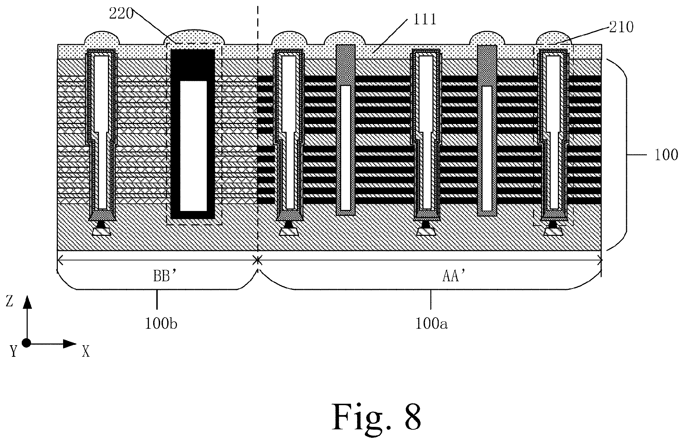

For the forming method of the semiconductor layer, the first soldering structure and the second soldering structure, present disclosure provides a variety of examples. Figs. 8 to 13 are structural diagrams of a forming process of the semiconductor layer, the first soldering structure and the second soldering structure provided in the present disclosure. Hereafter, the forming method of the semiconductor layer, the first soldering structure and the second soldering structure provided in an example of the present disclosure will be described in detail in connection with Fig. 6, Figs. 8-13.

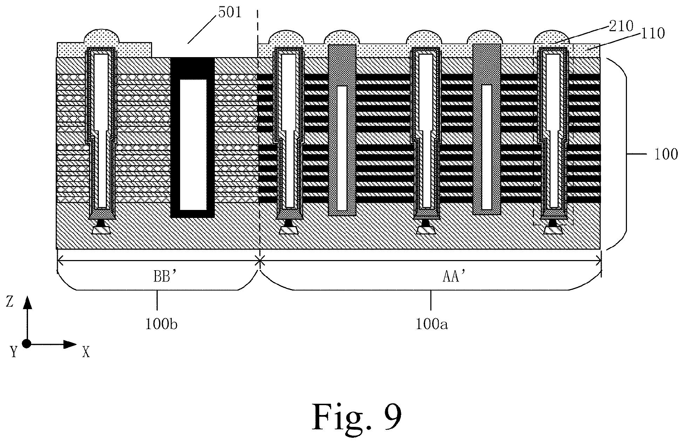

With reference to Figs. 8 and 9, step S20 is performed to form the semiconductor layer 110 over the stack structure 100 and the channel structure 210 from the side where the channel structure 210 protruding above the stack structure 100. The materials of the semiconductor layer 110 include at least one of polysilicon, poly-crystalline germanium and poly-crystalline silicon germanium.

In some examples, with reference to Figs. 8 and 9, forming the semiconductor layer 110 over the stack structure 100 and the channel structure 210 includes:
forming a semiconductor material layer 111 as shown in Fig. 8over the stack structure 100, the channel structure 210 and the contact structure 220 by a deposition process with an upper surface of the semiconductor material layer 111 being uneven, and since the semiconductor material layer 111 is formed conformally with the channel structure 210 and the contact structure 220, a thickness of the semiconductor material layer 111 in the Z direction remains the same. Since the channel structure 210 and the contact structure 220 protrude above the stack structure 100, the top surface of the semiconductor material layer 111 right above the channel structure 210 and the top surface of the semiconductor material layer 111 right above the contact structure 220 are higher than the top surface of the semiconductor material layer 111 right above the stack structure 100. A portion of the semiconductor material layer 111 right above the contact structure 220 is removed and in some examples at least a portion of the contact structure 220 above the top surface of the stack structure 100 can also be removed, so that a first opening 501 is formed to expose the contact structure 220 and the remaining of the semiconductor material layer 111 forms the semiconductor layer 110 as shown in Fig. 9.

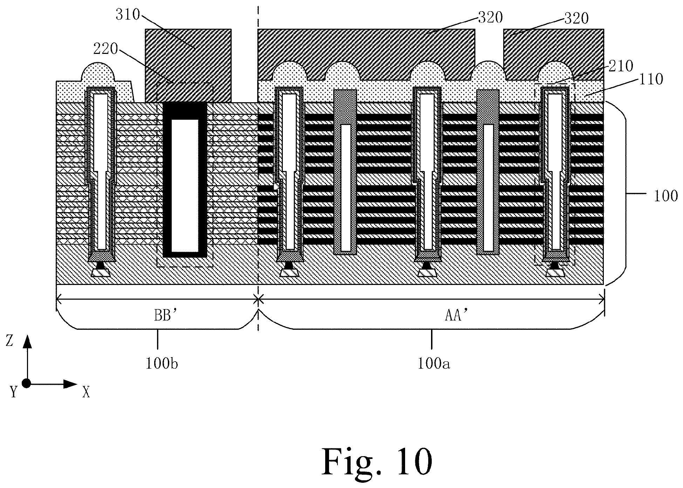

With reference to Fig. 10, step S30 is performed to form the first soldering structure 310 penetrating through the semiconductor layer 110 and connected with the contact structure 220, and the second soldering structure 320 connected with the semiconductor layer 110.

The first soldering structure 310 is configured to pad out the contact structure 220 and the second soldering structure 320 is configured to pad out the channel structure 210. The conductive materials used in the first soldering structure 310 and the second soldering structure 320 may include, but not limited to, aluminum.

In examples of the present disclosure, a soldering layer may be formed on the semiconductor layer 110 first and then processed through lithography and etching to form the first soldering structure 310 and the second soldering structure 320. It is to be noted that the numbers of the first soldering structures 310 and the second soldering structures 320 in Fig. 10 are only exemplary and not limited specifically in the present disclosure.

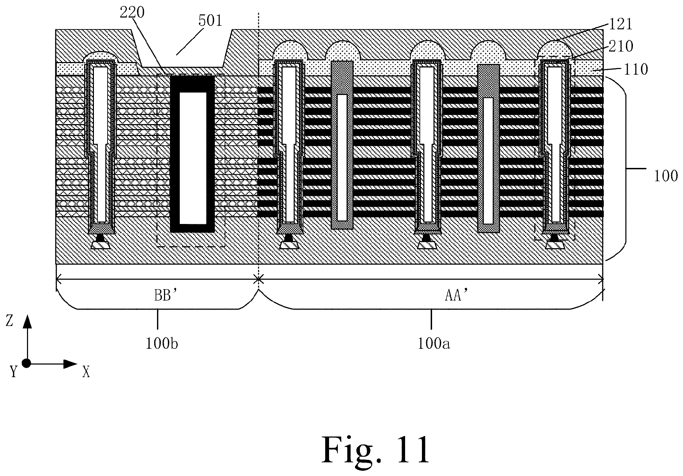

In some examples, with reference to Figs. 11 to 13, the method further includes: forming an isolating layer 121 covering sidewalls and bottom of the first opening 501 as well as the semiconductor layer 110 as shown in Fig. 11 using a deposition process; the isolating layer 121 covering the entirety of the semiconductor layer 110. The material used in the isolating layer 121 includes, but not limited to, silicon oxide.

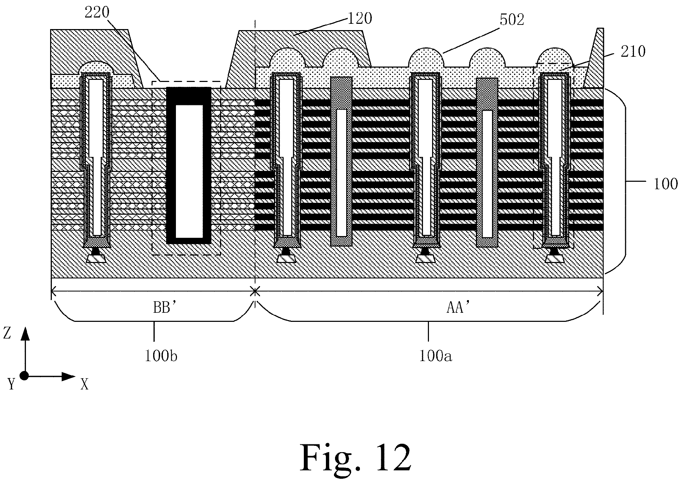

At least a portion of the isolating layer 121 on the bottom of the first opening 501 is removed using an etching process to expose the contact structure 220, and a portion of the isolating layer 121 on the semiconductor layer 110 is removed to form a second opening 502, through which the semiconductor layer 110 is exposed, so that the remaining portion of the isolating layer 121 forms an isolating structure 120 as shown in Fig. 12.

It is to be noted that the numbers of the first openings 501 and the second openings 502 in Fig. 12 are only exemplary and not limited specifically by the present disclosure.

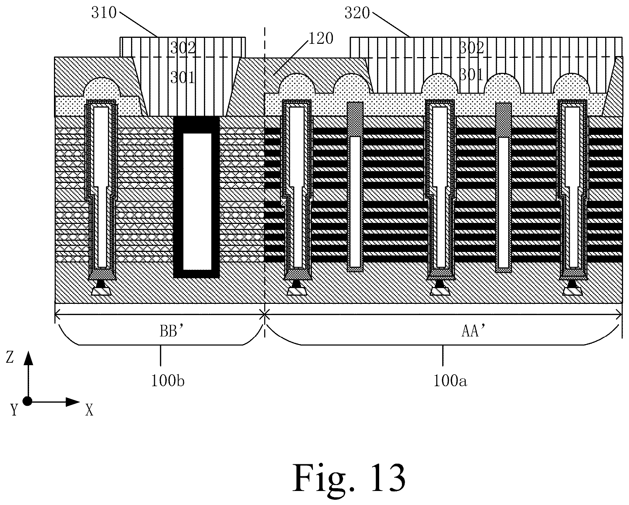

In some examples, with reference to Figs. 12 and 13, forming the first soldering structure 310 and the second soldering structure 320 includes:
after forming the isolating structure 120, forming at least the first soldering structure 310 in the first opening 501 using the deposition process and forming at least the second soldering structure 320 in the second opening 502 using the deposition process, the top surfaces of both the first soldering structure 310 and the second soldering structure 320 being higher than the top surface of the isolating structure 120. Each of the first soldering structure 310 and the second soldering structure 320 includes a first portion 301 and a second portion 302 on the first portion 301, the first portion 301 of the first soldering structure 310 being located in the first opening 501 and the first portion 301 of the second soldering structure 320 being located in the second opening 502.

In the example of the present disclosure, the first portion 301 and the second portion 302 may be formed integrally.

It can be understood that, in the above described example, the way the opening 501 and thus the semiconductor layer 110 are formed directly without a planarization process after forming the semiconductor material layer 111, can save the process flow and save process time.

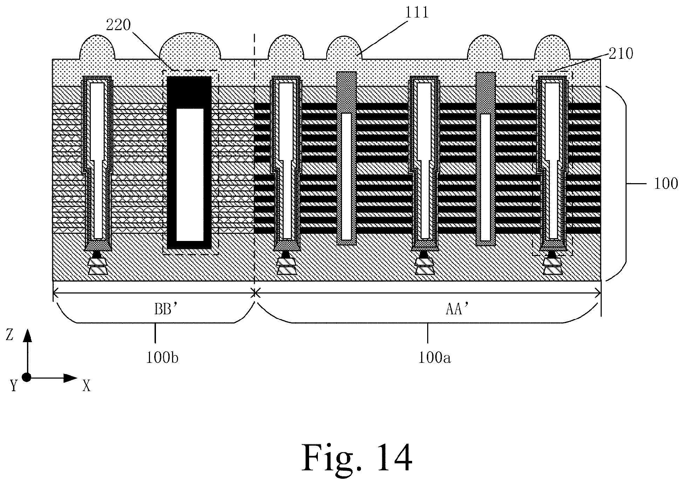

Figs. 14 to 19 are other structural diagrams of a forming process of the semiconductor layer, the first soldering structure and the second soldering structure provided in the present disclosure. Hereafter, a forming method of the semiconductor layer, the first soldering structure and the second soldering structure provided in an example of the present disclosure will be described in detail in connection with Fig. 6, Figs. 14 to 19.

With reference to Figs. 14 to 16, step S20 is performed to form the semiconductor layer 110 over the stack structure 100 and the channel structure 210 from the side where the channel structure 210 protruding above the stack structure 100.

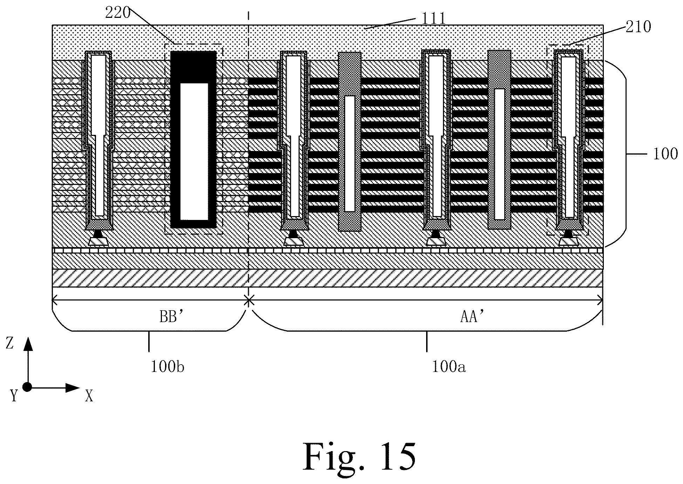

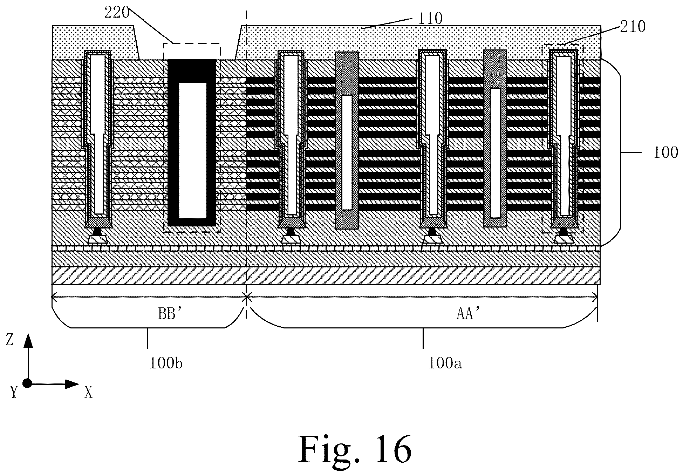

In some examples, with reference to Figs. 14 to 16, forming the semiconductor layer 110 over the stack structure 100 and the channel structure 210 further includes:
planarizing the semiconductor material layer 111 shown in Fig. 14 before forming the first opening 501, such that after the planarization, as shown in Fig. 15, the top surface of the semiconductor material layer 111 right above the channel structure 210 is flush with the top surface of the semiconductor material layer 111 right above the stack structure 100.
a portion of the semiconductor material layer 111 right above the contact structure 220 as shown in Fig. 15 is removed, so that the first opening 501 is formed to expose the contact structure 220 and the remaining of the semiconductor material layer 111 forms the semiconductor layer 110 as shown in Fig. 16.

In examples of the present disclosure, the semiconductor material layer 111 may be formed by a deposition process and then etched to form the semiconductor layer 110, which is finally crystallized through laser to form a laser-crystallized semiconductor layer 110, such as laser-crystallized polysilicon.

In some examples, the semiconductor material layer 111 may also be crystallized through laser to form a laser-crystallized semiconductor material layer 111, which is then etched to form the laser-crystallized semiconductor layer 110.

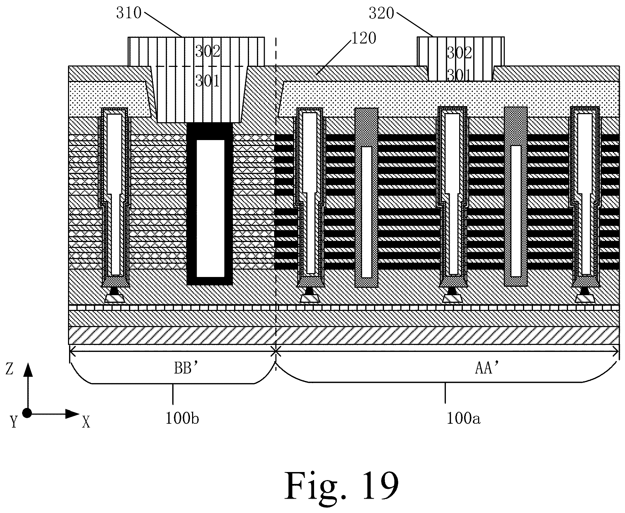

With reference to Fig. 19, step S30 is performed to form the first soldering structure 310 penetrating through the semiconductor layer 110 and connected with the contact structure 220, and the second soldering structure 320 connected with the semiconductor layer 110.

The first soldering structure 310 is configured to pad out the contact structure 220 and the second soldering structure 320 is configured to pad out the channel structure 210. The conductive materials used in the first soldering structure 310 and the second soldering structure 320 may include, but not limited to, aluminum.

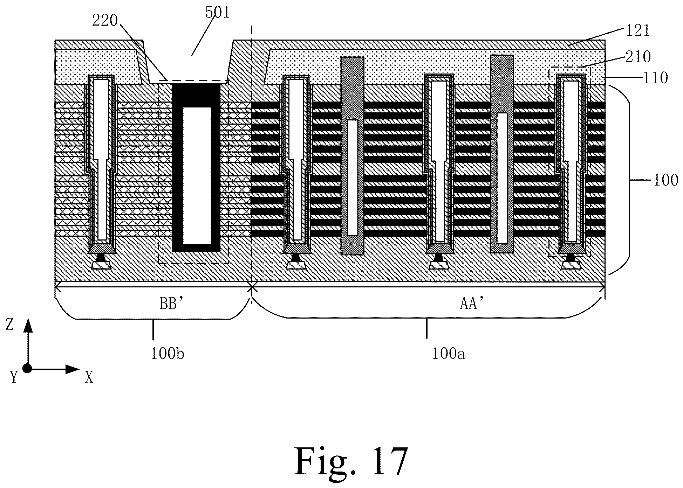

In some examples, with reference to Figs. 17 to 19, the method further includes: forming an isolating layer 121 covering sidewalls and bottom of the first opening 501 as well as the semiconductor layer 110 as shown in Fig. 17 using a deposition process; the isolating layer 121 covering the entirety of the semiconductor layer 110. The material used in the isolating layer 121 includes, but not limited to, silicon oxide.

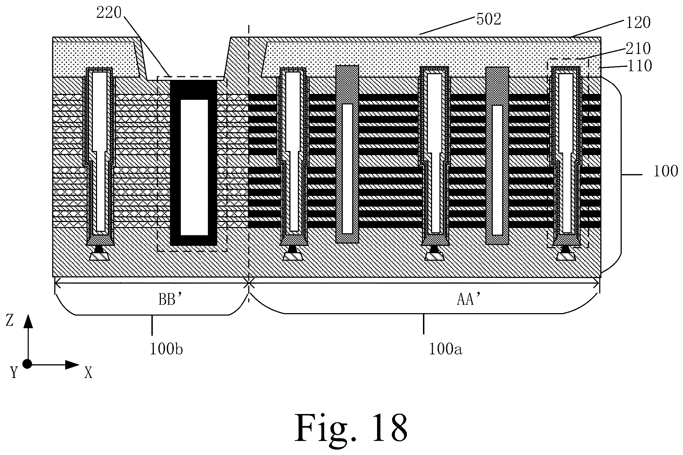

At least a portion of the isolating layer 121 on the bottom of the first opening 501 is removed using an etching process to expose the contact structure 220, and a portion of the isolating layer 121 on the semiconductor layer 110 is removed to form a second opening 502, through which the semiconductor layer 110 is exposed, and the remaining portion of the isolating layer 121 forms the isolating structure 120 as shown in Fig. 18.

It is to be noted that the numbers of the first openings 501 and the second openings 502 in Fig. 18 are only exemplary and not limited specifically by the present disclosure.

In some examples, with reference to Fig. 19, forming the first soldering structure 310 and the second soldering structure 320 includes:
after formation of the isolating layer 120, forming at least the first soldering structure 310 in the first opening 501 using a deposition process and forming at least the second soldering structure 320 in the second opening 502 using a deposition process, with the top surfaces of both the first soldering structure 310 and the second soldering structure 320 being higher than the top surface of the isolating structure 120. Each of the first soldering structure 310 and the second soldering structure 320 includes a first portion 301 and a second portion 302 on the first portion 301. The first portion 301 of the first soldering structure 310 is located in the first opening 501 and the first portion 301 of the second soldering structure 320 is located in the second opening 502.

The first soldering structure 310 and the second soldering structure 320 may be used for testing and also for connection with other external components or semiconductor structures. In some examples, a size of the second portion 302 in the X direction is larger than a size of the first portion 301 in the X direction, such that an area for contact with other components can be increased and thus the possibility of poor contact between the other components and the above-described soldering structures can be reduced.

In examples of the present disclosure, the first portion 301 and the second portion 302 are formed integrally. A soldering layer covering the isolating structure 120 may be formed on the isolating structure 120 using a deposition process and then recessed to form trenches therein so as to form the first soldering structure 310 and the second soldering structure 320.

In examples of the present disclosure, the conductive materials used in the first soldering structure 310 and the second soldering structure 320 may be aluminum. The first soldering structure 310 and the second soldering structure 320 can be formed in one deposition process, which reduces the process cost. The first soldering structure 310 and the second soldering structure 320 may be configured to pad out the contact structure 220 and the channel structure 210 respectively, thus avoiding to pad out the contact structure 220 and the channel structure 210 using conductive via structures with high aspect ratios, which are difficult to form by etching and may also exert limitation on the types of the conductive materials filled in the vias.

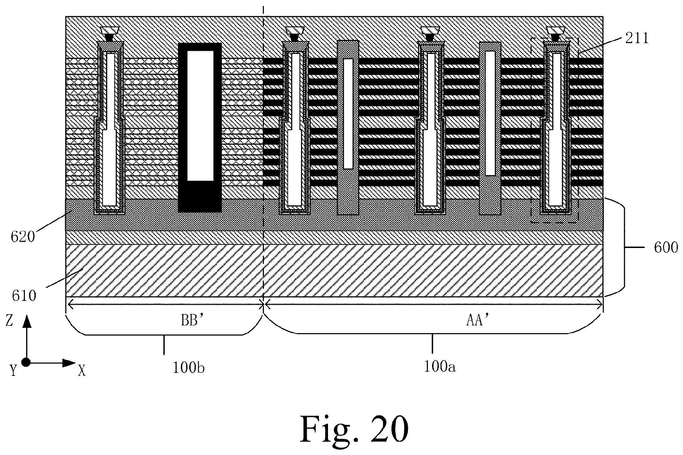

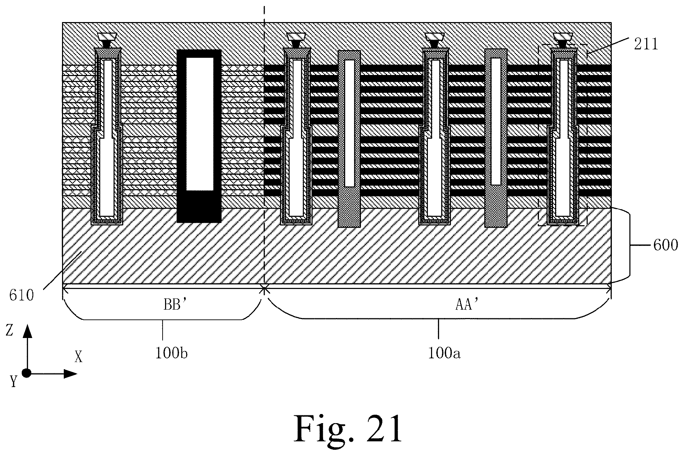

In some examples, providing the stack structure 100, the contact structure 220 and the channel structure 210 includes:
forming the stack structure 100, the contact structure 220 and the channel structure 210 on a base structure 600 as shown in Figs. 20 and 21. The base structure 600 includes a substrate 610 and a first semiconductor layer 620 between the substrate 610 and the stack structure 100, and the channel structure 210 extends into the first semiconductor layer 620. Alternatively, the base structure 600 includes a substrate 610 and the channel structure 210 extends into the substrate 610; and
removing the base structure 600 to expose a portion of the channel structure 210.

In some examples, as shown in Fig. 20, the base structure 600 may include the substrate 610 and the first semiconductor layer 620. The channel structure 210 extends into the first semiconductor layer 620.

In some examples, as shown in Fig. 21, the base structure 600 may include the substrate 610. The channel structure 210 extends into the substrate 610.

The substrate 610 may be a semiconductor material substrate of a single material (e.g., a silicon substrate, a germanium substrate or the like), a composite semiconductor material substrate (e.g., a germanium-silicon substrate), a silicon on insulator (SOI) substrate, a germanium on insulator (GeOI) substrate or the like.

The materials used in the first semiconductor layer 620 include, but not limited to, polysilicon, poly-crystalline germanium, and poly-crystalline silicon germanium.

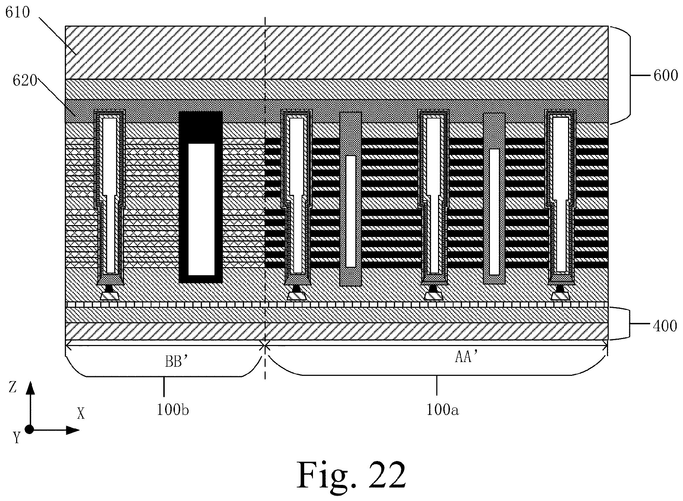

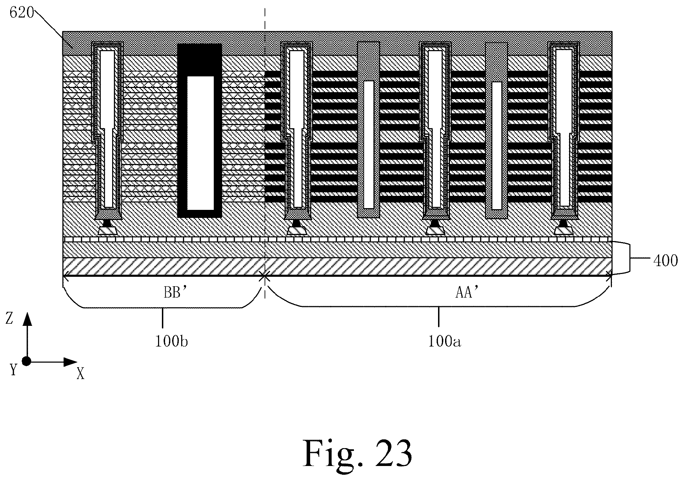

Examples of the present disclosure further provide a forming method of a semiconductor device, which will be further explained in connection with Figs. 22 and 23.

In some examples, a first semiconductor structure 400 including a peripheral circuitry (not shown in Fig. 22) as shown in Fig. 22 may be provided first, and then bonded to the structure shown in Fig. 20 or 21 on a side of the structure away from the base structure 600 in the Z direction, such that the base structure 600 faces upward as shown in Fig. 22. Subsequently, the substrate 610 and a first isolating layer between the substrate 610 and the first semiconductor layer 620, as shown in Fig. 20, are removed by an etching process or the substrate 610 as shown in Fig. 21 is removed by the etching process, so as to form the structure shown in Fig. 23. Thereafter, the first semiconductor layer 620 shown in Fig. 23 is removed and then a semiconductor layer, a first contact structure and a second contact structure are formed using the method of forming the semiconductor structure as described above, so as to form a semiconductor device. It is to be noted that Figs. 7 to 21 may further include the first semiconductor structure (not shown).

In some other examples, the semiconductor layer, the first soldering structure and the second soldering structure may be formed using the method of forming the semiconductor structure as described above, and then the first semiconductor structure can be bonded to the semiconductor structure on the side away from the semiconductor layer in the Z direction to form the semiconductor device.

In some examples, the channel structure 210 includes a channel layer and a functional layer surrounding the channel layer, and after removing the base structure 600 to expose a portion of the functional layer, the method further includes:
after removing the base structure 600, removing the exposed portion of the functional layer to expose a portion of the channel layer.

In some examples, the channel structure 210 can be formed by etching the initial channel structure 211, as shown in Fig. 20 or 21, which includes an initial functional layer and a channel layer. After removing the base structure 600, the portion of the initial functional layer above the top of the stack structure 100 is exposed and may be removed using an etching process to form the functional layer and expose a portion of the channel layer.

Although the present disclosure has been described with reference to specific examples, those of ordinary skills in the art should appreciate that the examples are only configured to explain the present disclosure and equivalent variations or substitutions can be made without departing from the spirit of the present disclosure. Therefore, all the changes and variations made to the examples fall within the scope of the claims of the present application as long as they are within the spirit of the present disclosure.

## Claims

1. A semiconductor structure, comprising:
a stack structure;
a semiconductor layer on the stack structure;
a channel structure extending through the stack structure and into the semiconductor layer;
a contact structure extending along a stacking direction of the stack structure; and
a first soldering structure and a second soldering structure, wherein the first soldering structure penetrates through the semiconductor layer and is connected with the contact structure and the second soldering structure is connected with the semiconductor layer.

2. The semiconductor structure of claim 1, wherein each of the first soldering structure and the second soldering structure comprises a first portion and a second portion on the first portion, and wherein a size of the second portion in a first direction is larger than a size of the first portion in the first direction with the first direction being perpendicular to the stacking direction.

3. The semiconductor structure of claim 2, wherein the size of the first portion in the first direction is a first size and a size of the first portion in the stacking direction is a second size, and the ratio of the second size to the first size is smaller than 1:5.

4. The semiconductor structure of claim 2, wherein the first portion and the second portion are formed integrally

5. The semiconductor structure of claim 1, wherein the portion of the channel structure extending into the semiconductor layer has a size in the stacking direction smaller than 200nm.

6. The semiconductor structure of claim 1, wherein a top surface of the semiconductor layer right above the channel structure is flush with a top surface of the semiconductor layer right above the stack structure.

7. The semiconductor structure of claim 1, wherein a top surface of the semiconductor layer right above the channel structure is higher than a top surface of the semiconductor layer right above the stack structure.

8. The semiconductor structure of claim 1, wherein materials of the first soldering structure and materials of the second soldering structure both comprise aluminum.

9. The semiconductor structure of claim 1, wherein the semiconductor structure further comprises:
an isolating structure located at least between the first soldering structure and the semiconductor layer.

10. The semiconductor structure of claim 1, wherein the stack structure comprises first material layers and insulating layers that are stacked alternately, and comprises a third portion and a fourth portion that are arranged side by side in a direction perpendicular to the stacking direction; the contact structure penetrates through the third portion and the channel structure penetrates through the fourth portion; and the first material layers in the third portion comprise sacrificial layers and the first material layers in the fourth portion comprise conductive layers.

11. The semiconductor structure of claim 1, wherein the channel structure comprises a functional layer located in the stack structure and a channel layer located in the stack structure and extending into the semiconductor layer, the functional layer covering sidewalls of the channel layer in the stack structure.

12. A semiconductor device, comprising a first semiconductor structure and the semiconductor structure of any one of claims 1 to 11,
wherein the first semiconductor structure is located on one of the two opposite sides of the semiconductor structure away from the semiconductor layer in the stacking direction and is connected with the semiconductor structure through hybrid bonding.

13. The semiconductor device of claim 12, wherein the first semiconductor structure comprises:
a peripheral circuitry connected with the contact structure in the semiconductor structure.

14. A forming method of a semiconductor structure, comprising:
providing a stack structure, a contact structure and a channel structure, wherein the channel structure penetrates through the stack structure and protrudes above the stack structure and the contact structure extends along a stacking direction of the stack structure;
forming a semiconductor layer over the stack structure and the channel structure from a side where the channel structure protruding above the stack structure; and
forming a first soldering structure and a second soldering structure, wherein the first soldering structure penetrates through the semiconductor layer and is connected with the contact structure and the second soldering structure is connected with the semiconductor layer.

15. The forming method of claim 14, wherein the forming the semiconductor layer over the stack structure and the channel structure comprises:
forming a semiconductor material layer over the stack structure, the channel structure and the contact structure, a top surface of the semiconductor material layer right above the channel structure and a top surface of the semiconductor material layer right above the contact structure being higher than a top surface of the semiconductor material layer right above the stack structure; and removing a portion of the semiconductor material layer to form a first opening exposing the contact structure, the remaining of the semiconductor material layer forming the semiconductor layer.

16. The forming method of claim 15, wherein the forming the semiconductor layer over the stack structure and the channel structure further comprises:
before forming the first opening, planarizing the semiconductor material layer, such that the top surface of the semiconductor material layer right above the channel structure is flush with the top surface of the semiconductor material layer right above the stack structure.

17. The forming method of claim 15, wherein the method further comprises: forming an isolating layer covering sidewalls and bottom of the first opening as well as the semiconductor layer;
removing at least a portion of the isolating layer on the bottom of the first opening to expose the contact structure; and removing a portion of the isolating layer on the semiconductor layer to form a second opening, through which the semiconductor layer is exposed, and the remaining of the isolating layer forming a isolating structure.

18. The forming method of claim 17, wherein the forming the first soldering structure and the second soldering structure comprises:
after forming the isolating structure, forming the first soldering structure at least in the first opening and forming the second soldering structure at least in the second opening, wherein each of the first soldering structure and the second soldering structure comprises a first portion and a second portion on the first portion, the first portion of the first soldering structure being located in the first opening and the second portion of the second soldering structure being located in the second opening.

19. The forming method of claim 14, wherein the providing the stack structure, the contact structure and the channel structure comprises:
forming the stack structure, the contact structure and the channel structure on a base structure, wherein the base structure comprises a substrate and a first semiconductor layer between the substrate and the stack structure, the channel structure extending into the first semiconductor layer; or the base structure comprises a substrate and the channel structure extends into the substrate; and
removing the base structure to expose a portion of the channel structure.

20. The forming method of claim 19, wherein the channel structure comprises a channel layer and a functional layer surrounding the channel layer, and after removing the base structure to expose a portion of the functional layer, the method further comprises:
after removing the base structure, removing the exposed portion of the functional layer to expose a portion of the channel layer.
